# EUROPÄISCHE PATENTSCHRIFT

(11) **EP 1 744 355 B1**
(45) Veröffentlichungstag und Bekanntmachung des Hinweises auf die Patenterteilung: **07.08.2019**
(21) Anmeldenummer: 06076347.1
(22) Anmeldetag: 28.06.2006
(51) Int. Cl.: B65G 49/06, H01L 21/67, H01L 21/673

(54) **Wafermagazin für Halbleiterwafer oder waferartige Gegenstände**
Wafer carrier for semiconductor wafers or similar objects
Magasin pour plaquettes de semiconducteurs ou d'objets similaires

(30) Priorität: 12.07.2005 DE 102005033859
(43) Veröffentlichungstag der Anmeldung: 17.01.2007
(73) Patentinhaber: Hanwha Q CELLS GmbH, 06766 Bitterfeld-Wolfen (DE)
(72) Erfinder: Killer, Heiko, 06809 Roitzsch (DE)
(74) Vertreter: Maikowski & Ninnemann Patentanwälte Partnerschaft mbB

(56) Entgegenhaltungen:
- EP-A- 0 762 483
- JP-A- 5 116 832
- US-A- 3 915 317
- US-A- 5 113 992
- US-A- 5 466 109
- US-A1- 2004 134 829
- US-A1- 2005 056 371
- US-B1- 6 427 096

## Beschreibung

Die Erfindung betrifft ein Wafermagazin für Halbleiterwafer oder waferartige Gegenstände mit den Merkmalen gemäß dem Oberbegriff des Anspruchs 1.

Der Einfachheit halber wird im Nachfolgenden nur noch von einem Wafermagazin und von Wafern gesprochen. Alle der folgenden Ausführungen beziehen sich jedoch ebenso auf waferartige Gegenstände wie zum Beispiel Dünnschichtsolarzellen in Form von Halbleiterdünnschichten auf Glassubstraten.

Die JP 5 116832 A beispielsweise zeigt eine Vorrichtung zum Lagern von scheibenartigen Gegenständen. Die Vorrichtung umfasst vier vertikal angeordnete Umlaufbänder, die von einer Steuereinheit gesteuert werden. An den Umlaufbändern sind Aufnahmen angeordnet, auf die die zu lagernden Gegenstände angeordnet werden können. Bei der JP 5 116832 A sind die Gegenstände im Wesentlichen rechteckig und die Umlaufbänder sind derart angeordnet, dass ihre Aufnahmen einen jeweiligen Gegenstand an seinen vier Ecken aufnehmen. Aus dem Stand der Technik sind eine Vielzahl von Wafermagazinen bekannt, die insbesondere für die Zwischenlagerung von Halbleiterwafern in verschiedenen Bearbeitungsstadien bei automatisierten Anlagen der Halbleitertechnologie zum Einsatz kommen.

Eine kompakte Ausführung eines solchen Wafermagazins umfasst eine Grundplatte, die auf einem Grundkörper aufliegt, ohne an dieser befestigt zu sein. Grundplatte und Grundkörper liegen gemeinsam auf einer Grundfläche auf. Am Grundkörper sind eine Mehrzahl von Begrenzungsstrukturen befestigt, die sich quer, insbesondere senkrecht, zur Grundfläche erstrecken. Diese Begrenzungsstrukturen sind um die Grundplatte herum angeordnet und bilden eine nach oben hin offene käfigartige Gesamtstruktur aus. Die Begrenzungsstrukturen sind beispielsweise in Form gleich lang ausgebildeter Holme vorgesehen.

Auf dem durch den Grundkörper und die umlaufenden Begrenzungsstrukturen definierten Boden dieser käfigartigen Gesamtstruktur liegt die Grundplatte lose auf. In Kombination mit einer Antriebseinheit lässt sich die Grundplatte entlang einer im wesentlichen senkrecht zur Grundfläche orientierten Verfahrrichtung zwischen dem oberen Rand der Begrenzungsstrukturen und der Auflagefläche der Grundplatte am Boden auf und ab bewegen. Als Antriebseinheit ist beispielsweise ein mittels einer Spindel eines Schrittmotors angetriebener Kolben vorgesehen, der den Grundkörper von unten her durchgreift und die Grundplatte von dem Grundkörper weg nach oben drückt.

In der oberen Position der Grundplatte kann ein Greifarm einen am Greifarm fixierten Wafer über die Grundplatte verschwenken. Dort kommt der Wafer in einem definierten Abstand weniger Millimeter parallel zur Grundplatte zu liegen. Dann löst sich die Fixierung des Wafers zum Greifarm, so dass der Wafer nach einer Fallstrecke des Abstands zur Grundplatte auf die Oberfläche der Grundplatte fällt. Die Grundplatte wird mittels der Antriebseinheit etwas nach unten gesenkt, und der Beschickungsvorgang kann von neuem beginnen. Dabei fällt der nächste Wafer direkt auf die Oberfläche des vorangehenden. Über Sensoren gesteuert wird die Grundplatte dabei so positioniert, dass sich die Oberkante des Waferstapels stets auf einem bestimmten Niveau befindet. Dieser Vorgang lässt sich wiederholen, bis die Grundplatte auf dem Grundkörper zu liegen kommt und das Magazin keine weiteren Wafer mehr aufnehmen kann.

Auf diese Weise lassen sich eine größere Zahl von Wafern auf engem Raum lagern und als eine im Wafermagazin angeordnete Produktions-Einheit beispielsweise von einer ersten zu einer nachgeordneten Anlage transportieren, wo die Wafer den nächsten Prozessschritt durchlaufen.

Als problematisch erweisen sich bei einem solchen Wafermagazin, die ständigen Auf- und Abbewegungen der Grundplatte mit dem darauf befindlichen Waferstapel.

Durch mechanische Wechselwirkung mit den die Grundplatte umgebenden Begrenzungsstrukturen kommt es an den Kanten der Wafer zu so genannten Muschelbrüchen. Insbesondere das Material von Halbleiterwafern aber auch von Glasplättchen ist oftmals sehr spröde, so dass deren Kanten auf Punktlasten empfindlich reagieren. Bei mechanischer Belastung splittert das Material schnell und bildet dabei die charakteristischen terassenartigen Strukturen der Muschelbrüche.

Derartige Beschädigungen stellen für die Qualitätssicherung ein Problem dar und führen zu einer unerwünschten Erhöhung des Ausschusses bei der Produktion.

Der vorliegenden Erfindung liegt somit die Aufgabe zu Grunde, ein Wafermagazin bereit zu stellen, das die vorangehend genannten Nachteile überwindet und gleichzeitig einfach und kostengünstig aufgebaut ist.

Diese Aufgabe wird durch ein Wafermagazin mit den Merkmalen des Anspruchs 1 gelöst.

Die beiden beschriebenen Lösungen der Aufgabe, nämlich die flexible Ausbildung der Führungsmittel einerseits und die bestimmte Art und Weise der Zusammenwirkung der Führungsmittel mit der Grundplatte andererseits, basieren auf dem gemeinsamen Prinzip, die kritischen Reibungskräfte zwischen den Kanten des Waferstapels und den Begrenzungsstrukturen zu vermeiden bzw. zumindest zu reduzieren.

Erfindungsgemäß ist bei der einen Lösung vorgesehen, dass mehrere der Begrenzungsstrukturen jeweils eine der Grundplatte zugewandte Innenseite und jeweils eine Führungseinrichtung mit einem sich zumindest auf der Innenseite einer Begrenzungsstruktur erstreckenden Führungsmittel umfassen, wobei die Führungsmittel quer zur Verfahrrichtung flexibel ausgebildet sind.

Auf diese Weise ist gewährleistet, dass die Kanten der auf der Grundplatte gestapelten Wafer nur über die Führungsmittel mit den Begrenzungsstrukturen in mechanischen Kontakt treten. Dadurch, dass die Führungsmittel quer zur Verfahrrichtung flexibel ausgebildet sind, werden die mechanischen Belastungen der Kanten reduziert. Das Material der Führungsmittel ist derart ausgewählt, dass die Haft- und Gleitreibung der Waferkanten auf den Führungsmitteln gering ist. Die immer noch auftretenden geringen Reibungskräfte zwischen den Waferkanten und den Führungsmitteln, werden zumindest teilweise durch eine auf Grund der Flexibilität der Führungsmittel ermöglichte, quer zur Verfahrrichtung orientierte Ausweichbewegung der Führungsmittel aufgenommen. Als flexibel im Sinne der vorliegenden Erfindung ist ein Führungsmittel dann anzusehen, wenn es bei einer durch die Bewegung der Grundplatte verursachte mechanische Wechselwirkung mit einer Waferkante durch eine Relativbewegung zur Waferkante derart ausweicht, dass die Waferkante mit geringeren Kräften belastet wird, als wenn keine Relativbewegung des Führungsmittels aufträte. Die

Reduzierung der einwirkenden Kräfte ist dabei so groß, dass an den Waferkanten deutlich weniger Muschelbrüche auftreten.

Die dem gleichen Grundprinzip folgende zweite Lösung sieht vor, dass die Führungsmittel und die Grundplatte derart zusammenwirken, dass die Bewegung der Grundplatte entlang der Verfahrrichtung eine im Wesentlichen entlang der Verfahrrichtung orientierte und im Wesentlichen gleich schnelle Bewegung der Führungsmittel bewirkt.

Auf diese Weise ist eine Relativbewegung zwischen den in mechanischem Kontakt mit den Kanten des Waferstapels stehenden Führungsmitteln im Wesentlichen unterbunden. Das heißt, Führungsmittel und Wafer bewegen sich im besten Fall simultan und gleich schnell, so dass keine durch die Bewegung der Grundplatte verursachte Krafteinwirkung mehr auf die Kanten der Wafer entstehen kann. Dies stellt im Vergleich zur vorangehend genannten ersten Lösung die bessere Variante dar, da diese die kritischen Reibungskräfte nicht nur reduziert sondern sogar weitestgehend vermeidet.

Bei der zweiten Lösung ist es besonders einfach, die Relativbewegung dadurch zu unterbinden, dass die Führungsmittel mechanisch an der Grundplatte festgelegt sind. Dadurch ist die simultane Bewegung garantiert. Diese Variante impliziert, dass die Führungseinrichtungen entsprechend ausgebildet sind, damit die benötigte Bewegung der Führungsmittel sichergestellt ist.

Eine vorteilhafte Anwendungsform sieht vor, die Grundplatte so schwer, d.h. beispielsweise in entsprechend massiver Metallbauweise, auszubilden, dass deren Gewichtskraft größer ist als die Summe aller bei einer Bewegung der Grundplatte entlang der Verfahrrichtung über die Führungsmittel auf die Grundplatte wirkenden bewegungshemmenden Kräfte. Dies hat den Vorteil, dass die Antriebseinheit in Form eines von einem Schrittmotor von unten gegen die Grundplatte drückenden Stempels beim Absenken der Grundplatte keine Kraft auf die Grundplatte ausüben muss. Die Schwerkraft allein reicht aus, um die Grundplatte zurück auf den Grundkörper abzusenken. Senkt sich der Stempel der Antriebseinheit weiter als die unterste Position der Grundplatte, so wird die Antriebseinheit automatisch von der Grundplatte entkoppelt. Die Kraftkopplung zwischen Antriebseinheit und der Grundplatte erfolgt in der Gegenrichtung allein durch Kraftschluss.

Für beide der beschriebenen Lösungen ist es zweckmäßig, die Führungsmittel jeweils in Form von benachbart zur Innenseite einer Begrenzungsstruktur angeordnetes Führungsband vorzusehen. Derartige Bänder oder geeignete Riemen aus verschiedenen Kunststoffen sind als sehr preisgünstige Massenartikel auf dem Markt erhältlich.

Jedes Führungsband wird bevorzugt von einem oberen Positionierungsmittel und einem unteren Positionierungsmittel relativ zur Innenseite einer Begrenzungsstruktur positioniert. Dabei besteht eine zweckmäßige Variante darin, die Positionierungsmittel derart auszubilden, dass jedes Führungsband beabstandet von der benachbarten Innenseite einer Begrenzungsstruktur positioniert ist. Der Abstand des Führungsbandes führt automatisch zu einer Flexibilität des Führungsbandes quer zur Verfahrrichtung der Grundplatte.

Bevorzugt ist jedes obere Positionierungsmittel als eine obere Umlenkrolle zum Umlenken eines Führungsbandes um im Wesentlichen 180° ausgebildet. Diese Umlenkrolle ändert die Erstreckungsrichtung des Führungsbandes von der Innenseite einer Begrenzungsstruktur zu einer der Grundplatte abgewandten Außenseite der Begrenzungsstruktur.

Eine weitere Anwendungsform des Wafermagazins sieht eine zwischen jeder oberen Umlenkrolle und dem Grundkörper angeordnete Spannvorrichtung vor. Diese bevorzugt mechanisch wirkende Spannvorrichtung spannt das Führungsband entlang seiner Erstreckungsrichtung. Jedes untere Positionierungsmittel ist dabei als Fixierung des Führungsbandes entweder an der Begrenzungsstruktur oder an der Grundplatte vorgesehen.

Ist das Führungsband mechanisch an der Grundplatte festgelegt, so ist es denkbar, dass die Spannvorrichtung derart ausgebildet ist, dass diese beim Hochfahren der Grundplatte das sich über die obere Umlenkrolle bewegende Führungsband mittels eines federbelasteten Wickelmechanismus aufwickelt.

Eine alternative Anwendungsform des Wafermagazins sieht vor, jedes untere Positionierungsmittel als untere Umlenkrolle zum Umlenken des Führungsbandes um im Wesentlichen 180°auszubilden. Dadurch lässt sich das Führungsband als umlaufender, einteiliger Riemen ausbilden, der in sich geschlossen von der Innenseite der Begrenzungsstruktur zur Außenseite der Begrenzungsstruktur verläuft.

Diese Anwendungsform lässt sich in beiden grundsätzlichen Varianten der Erfindung realisieren. Zum einen ohne Zusammenwirken zwischen Grundplatte und Führungsmittel. Bei dieser Variante ist die Flexibilität der Führungsmittel quer zur Verfahrrichtung durch deren Beabstandung zur Innenseite der Begrenzungsstrukturen gegeben.

Bei der Variante, dass jedes Führungsband mechanisch an der Grundplatte festgelegt ist, treibt die Bewegung der Grundplatte die Umlaufbewegung der in sich geschlossenen Führungsmittel an.

Bevorzugt sind die als Umlenkrollen ausgebildete Positionierungsmittel um eine Drehachse derart drehbar gelagert, dass das Führungsband unter einer Drehung einer unteren und/oder oberen Umlenkrolle entlang seiner Erstreckungsrichtung bewegbar ist. Zur Reduzierung der bewegungshemmenden Kräfte sind die Umlenkrollen jeweils kugelgelagert ausgebildet.

Es ist zweckmäßig, die Umlenkrollen entlang ihrer Drehachse betrachtet mit gegenüber liegenden Führungswangen zur seitlichen Führung des Führungsbandes auszubilden. Dadurch ist ein sicherer Sitz des Führungsbandes auf den Umlenkrollen gewährleistet.

Bevorzugt sind die Umlenkrollen als Zahnräder und das Führungsband zumindest abschnittsweise als ein mit den Zahnrädern zusammenwirkender Zahnriemen ausgebildet.

Weitere Merkmale und Vorteile des Wafermagazins werden im Zusammenhang mit der Beschreibung der folgenden bevorzugten Ausführungsbeispiele erläutert.

Es zeigen:
- Figur 1: eine perspektivische Ansicht der bevorzugten Ausführungsform des Wafermagazins;
- Figur 2a: eine teilweise Seitenansicht des Wafermagazins aus Figur 1 gemäß der ersten Lösungsvariante entlang der mit den Pfeilen II in Figur 1 gezeigten Richtung;
- Figur 2b: eine Seitenansicht einer Abwandlung der ersten Lösungsvariante des Wafermagazins in der Perspektive gemäß Figur 2a;
- Figur 2c: eine teilweise Seitenansicht des Wafermagazins aus Figur 1 gemäß der zweiten Lösungsvariante entlang der mit den Pfeilen II in Figur 1 gezeigten Richtung; und
- Figur 2d: eine Seitenansicht einer Abwandlung der zweiten Lösungsvariante des Wafermagazins in der Perspektive gemäß Figur 2c.

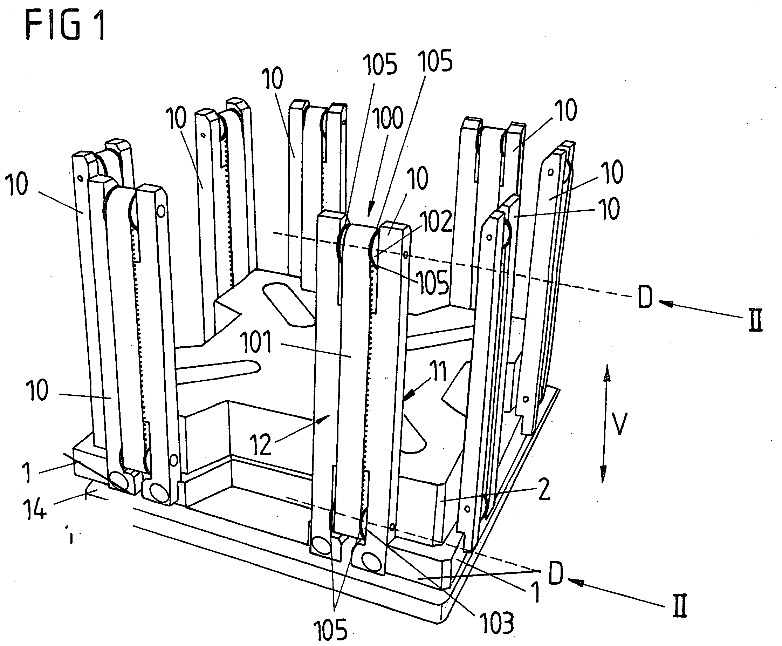

In Figur 1 ist die perspektivische Ansicht einer bevorzugten Ausführungsform des Wafermagazins dargestellt.

Auf einem Grundkörper 1, der rahmenförmig ist und eine im Wesentlichen quadratische Grundfläche abdeckt, ist eine Grundplatte 2 angeordnet. An den vier Seiten des Grundkörpers 1 sind jeweils zwei Begrenzungsstrukturen 10 in Form von Begrenzungsholmen gegenüberliegend symmetrisch angeordnet. Diese Begrenzungsholme erstrecken sich senkrecht zur Grundfläche und sind alle identisch zueinander ausgebildet. Sie bilden zusammen mit dem Grundkörper 1 und der auf dieser liegenden Grundplatte 2 die Gesamtstruktur eines nach oben offenen Käfigs.

Auf die Grundplatte 2 lassen sich Wafer bis zum oberen Rand der Begrenzungsholme aufeinander gestapelt ablegen. Das Beschicken und Entnehmen der Wafer erfolgt wie in der Beschreibungseinleitung dargestellt.

Um das Wafermagazin in einer Anlage zur Bearbeitung der Wafer einfach und definiert einsetzen zu können, umfasst der Grundkörper 1 eine mechanische Montagestruktur in Form einer entlang einer oder mehrerer Seiten verlaufenden Nut 14. Mittels dieser Nut 14 lässt sich das Wafermagazin in einen an der Anlage vorgesehenen, korrespondierend ausgebildeten mechanischen Führungsmechanismus einschieben.

Jeder Begrenzungsholm ist aus einem quaderförmigen, gestreckten Grundkörper aufgebaut. Zur Grundplatte 2 hin weisen die Begrenzungsholme jeweils eine Innenseite 11 , von der Grundplatte 2 abgewandt eine Außenseite 12 auf.

Jeder Begrenzungsholm umfasst eine Führungseinrichtung 100. Diese Führungseinrichtung 100 weist insbesondere ein Führungsmittel 101 in Form eines Führungsbandes auf. Dieses Führungsband ist als geschlossener Zahnriemen ausgebildet, der beabstandet von der Innenseite 11 und der Außenseite 12 entlang der Erstreckungsrichtung des Begrenzungsholms von dessen unterem Ende zu dessen oberem Ende verläuft. An den beiden Enden sind jeweils ein oberes und ein unteres Positionierungsmittel 102, 103 in Form von Umlenkrollen vorgesehen, die den in sich geschlossenen Zahnriemen von der Innenseite 11 auf die Außenseite 12 des Begrenzungsholms umlenken.

Der Zahnriemen ist in Form eines Flachbandes vorgesehen, der ausschließlich auf der zum Begrenzungsholm hin orientierten Seite Zähne aufweist. Auf der anderen Seite weist der Zahnriemen eine glatte Oberfläche auf. Die obere und die untere Umlenkrolle sind als mit den Zähnen des Zahnriemens zusammenwirkende Zahnräder ausgebildet, die jeweils um Drehachsen D rotierbar gelagert sind. Diese Zahnräder weisen an ihren in Bezug auf die Drehachse D außen angeordneten Randbereichen Führungswangen 105 auf, die ein Verrutschen des Zahnriemens entlang der Drehachsen D verhindert.

Die Grundplatte 2 umfasst keinerlei Fixiermittel zur Befestigung am Grundkörper 1. Die Grundplatte 2 liegt lose auf dem Grundkörper 1 auf, damit sich diese zusammen mit den auf der Grundplatte 2 gestapelten Wafern entlang einer senkrecht zur Grundfläche orientierten Verfahrrichtung V relativ zu den Begrenzungsholmen bewegen lässt.

Die Grundplatte 2 erstreckt sich zumindest im Bereich der Innenseiten 11 der Begrenzungsholme bis an die Führungsbänder heran.

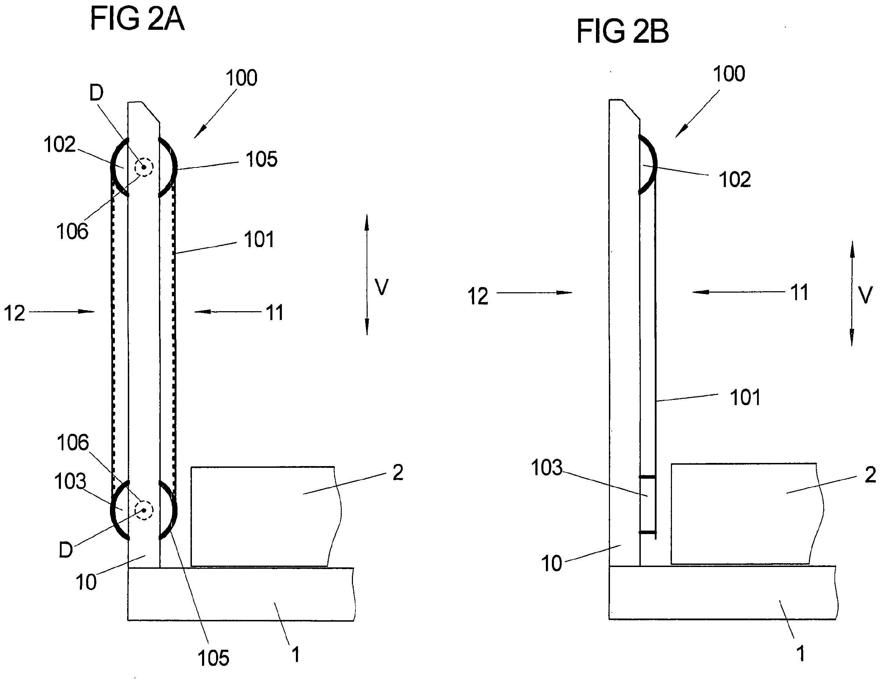

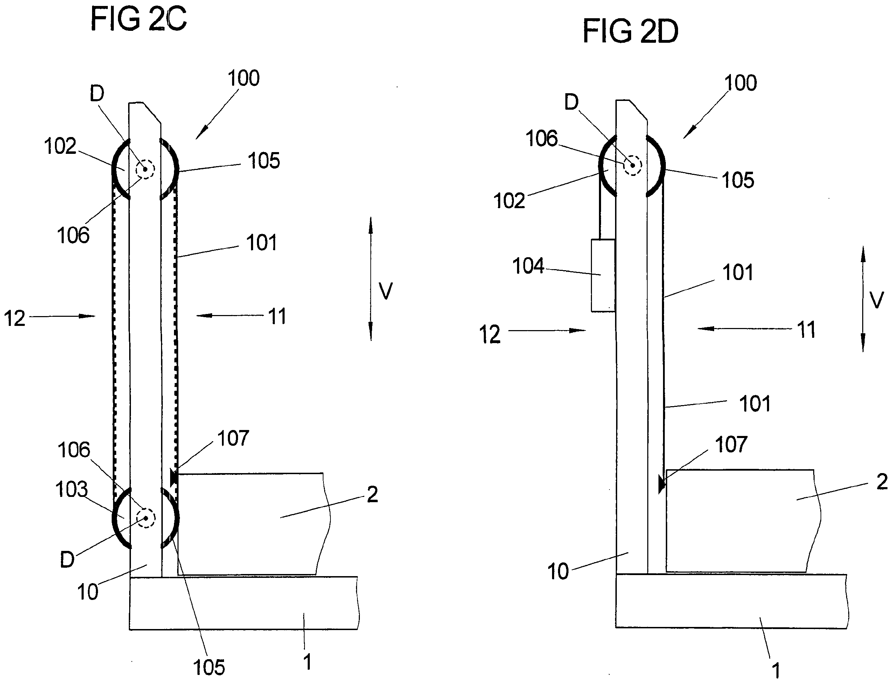

Der angrenzende Bereich zwischen den Begrenzungsholmen und der Grundplatte 2 ist entlang der in der Figur 1 mit den Pfeilen II - II gezeigten Perspektive in den Figuren 2a und 2c für die beiden grundsätzlichen Lösungsvarianten dargestellt.

Figur 2a zeigt die Variante, dass das Führungsband mit der Grundplatte 2 nicht in Wechselwirkung steht. Das Führungsband ist auf der Innenseite 11 des Begrenzungsholms durch die entsprechend breite Ausbildung der oberen und unteren Zahnräder beabstandet von der Innenseite 11 angeordnet. Dadurch ist eine Flexibilität des Führungsbandes quer zur Verfahrrichtung V gegeben. Das obere und das untere Zahnrad sind jeweils mit Kugellagern 106 um deren Drehachsen D gelagert. Dadurch werden besonders geringe bewegungshemmende Kräfte des in sich geschlossenen Zahnriemens gewährleistet. Dies kann auch bei dieser ersten Lösungsvariante von Vorteil sein, weil der Zahnriemen bei entsprechend starken Reibungskräften zwischen diesem und den Waferkanten mitbewegt wird.

Dieser Effekt ist bei der in Figur 2c dargestellten zweiten Variante erzwungen. Der Aufbau des gezeigten Ausschnitts eines Wafermagazins entspricht dem der Figur 2a, so dass auf die dort gemachten Ausführungen verwiesen werden kann. Im Unterschied zur ersten Variante ist das als Zahnriemen ausgebildete Führungsband durch ein Befestigungsmittel 107, beispielsweise in Form einer Schraube, mechanisch an der Grundplatte 2 festgelegt. Dadurch erzwingt eine Bewegung der Grundplatte 2 entlang der Verfahrrichtung V eine gleich gerichtete, gleich schnelle Bewegung des Führungsbandes. Dieses Ausführungsbeispiel wird als das bevorzugteste angesehen.

Die Figuren 2b und 2d zeigen jeweils Abwandlungen der in den Figuren 2a und 2c gezeigten ersten und zweiten Lösungsvariante. Beide Abwandlungen haben gemeinsam, dass das Führungsmittel 101 nicht als in sich geschlossener Riemen ausgebildet ist. Vielmehr ist das Führungsmittel 101 in Form eines im Wesentlichen nur entlang der Innenseite 11 des Begrenzungsholms angeordnetes Führungsband vorgesehen.

Gemäß der in Figur 2b gezeigten ersten Lösungsvariante sind auf der Innenseite 11 nur ein oberes und ein unteres Positionierungsmittel 102, 103 zum beabstandeten Anordnen des Führungsmittels 101 vorgesehen. Dies stellt auf Grund der unbeweglich ausgebildeten oberen und unteren Positionierungsmittel das am einfachsten aufgebaute Ausführungsbeispiel dar.

Bei der in Figur 2d gezeigten zweiten Lösungsvariante ist das Führungsband im Bereich der Grundplatte 2 durch ein Befestigungsmittel 107 mit der Grundplatte 2 gekoppelt. Dadurch wird die Bewegung der Grundplatte 2 auf das Führungsband übertragen. Auf der Außenseite 12 des Begrenzungsholms ist eine Spannvorrichtung 104 vorgesehen. Diese Spannvorrichtung 104 gewährleistet, dass das durch die Bewegung der Grundplatte 2 bewegte Führungsmittel 101 immer unter der gleichen mechanischen Vorspannung steht. Dazu ist es notwendig, die Spannvorrichtung 104 mit einem Wickelmechanismus zu versehen, die das bei der Auf- und Abwärtsbewegung der Grundplatte 2 zugeführte Führungsmittel 101 auf- bzw. abwickelt.

Es ist selbstverständlich, dass die gezeigte quadratische Grundform des Grundkörpers 1 und der Grundplatte 2 keineswegs zwingend sind. Ebenso ist ein an der Form der Wafer orientierter rechteckiger oder runder Aufbau möglich. Außerdem ist die Anzahl der Begrenzungsstrukturen 10 weitgehend variabel. Bei einer viereckigen Grundform sind üblicherweise an jeder Seite zumindest eine Begrenzungsstruktur 10 notwendig, um eine allseitige Führung und Sicherung des Waferstapels zu gewährleisten. Bei einem runden Aufbau wären dafür zumindest drei entsprechend verteilt angeordnete Begrenzungsstrukturen notwendig.

### Bezugszeichenliste

- 1: Grundkörper
- 2: Grundplatte
- 10: Begrenzungsstruktur
- 11: Innenseite
- 12: Außenseite
- 14: Nut
- 100: Führungseinrichtung
- 101: Führungsmittel
- 102: oberes Positionierungsmittel
- 103: unteres Positionierungsmittel
- 104: Spannvorrichtung
- 105: Führungswange
- 106: Kugellager
- 107: Befestigungsmittel
- D: Drehachse
- V: Verfahrrichtung

## Patentansprüche

1. Wafermagazin für Halbleiterwafer oder waferartige Gegenstände mit
• einem Grundkörper (1), der auf einer Grundfläche aufliegt,
• einer Mehrzahl von Begrenzungsstrukturen (10), die an dem Grundkörper (1) festgelegt sind und quer zur Grundfläche verlaufen, und
• einer auf dem Grundkörper (1) zwischen den Begrenzungsstrukturen (10) aufliegenden Grundplatte (2), die sich entlang einer im Wesentlichen senkrecht zur Grundfläche orientierten Verfahrrichtung (V) entlang der Begrenzungsstrukturen (10) bewegen lässt,
wobei mehrere der Begrenzungsstrukturen (10) jeweils eine der Grundplatte (2) zugewandte Innenseite (11) und jeweils eine Führungseinrichtung (100) mit einem sich zumindest auf der Innenseite (11) einer Begrenzungsstruktur (10) erstreckenden Führungsmittel (101) umfassen, und wobei die Führungsmittel (101) quer zur Verfahrrichtung (V) flexibel ausgebildet sind oder mit der Grundplatte (2) derart zusammenwirken, dass die Bewegung der Grundplatte (2) entlang der Verfahrrichtung (V) eine im Wesentlichen entlang der Verfahrrichtung (V) orientierte und im Wesentlichen gleich schnelle Bewegung der Führungsmittel (101) bewirkt, **dadurch gekennzeichnet, dass** die Führungsmittel (101) so angeordnet sind, dass ein auf der Grundplatte (2) anzuordnender Wafer oder waferartiger Gegenstand nur über die Führungsmittel (101) mit den mehreren der Begrenzungsstrukturen (10) in mechanischen Kontakt tritt.

2. Wafermagazin gemäß Anspruch 1, **dadurch gekennzeichnet, dass** die Führungsmittel (101) mechanisch an der Grundplatte (2) festgelegt sind.

3. Wafermagazin gemäß Anspruch 2, **dadurch gekennzeichnet, dass** die Grundplatte (2) so schwer ausgebildet ist, dass deren Gewichtskraft größer ist als die Summe aller bei einer Bewegung der Grundplatte (2) entlang der Verfahrrichtung (V) über die Führungsmittel (101) auf die Grundplatte (2) wirkenden bewegungshemmenden Kräfte.

4. Wafermagazin gemäß einem der Ansprüche 1 bis 3, **dadurch gekennzeichnet, dass** die Führungsmittel (101) jeweils als benachbart zur Innenseite (11) einer Begrenzungsstruktur (10) angeordnetes Führungsband ausgebildet sind.

5. Wafermagazin gemäß Anspruch 4, **dadurch gekennzeichnet, dass** die Führungseinrichtungen (100) jeweils ein oberes Positionierungsmittel (102) und ein unteres Positionierungsmittel (103) zur Positionierung des Führungsbandes aufweisen.

6. Wafermagazin gemäß Anspruch 5, **dadurch gekennzeichnet, dass** jedes Führungsband beabstandet von der benachbarten Innenseite einer Begrenzungsstruktur (10) positioniert ist.

7. Wafermagazin gemäß Anspruch 5 oder 6, **dadurch gekennzeichnet, dass** jedes obere Positionierungsmittel (102) als obere Umlenkrolle zum Umlenken eines Führungsbandes um im Wesentlichen 180° ausgebildet ist, wobei das Führungsband von der Innenseite (11) einer Begrenzungsstruktur (10) zu einer der Grundplatte (2) abgewandten Außenseite (12) der Begrenzungsstruktur (10) verläuft.

8. Wafermagazin gemäß Anspruch 7, **dadurch gekennzeichnet, dass** jede Führungseinrichtung (100) eine zwischen der oberen Umlenkrolle und dem Grundkörper (1) angeordnete Spannvorrichtung (104) aufweist, die das Führungsband entlang seiner Erstreckungsrichtung mechanisch vorspannt

9. Wafermagazin gemäß Anspruch 7, **dadurch gekennzeichnet, dass** jedes untere Positionierungsmittel (103) als untere Umlenkrolle zum Umlenken des Führungsbandes um im Wesentlichen 180° ausgebildet ist, wobei das Führungsband von der Innenseite (11) der Begrenzungsstruktur (10) zur Außenseite (12) der Begrenzungsstruktur (10) verläuft und als umlaufender, einteiliger Riemen ausgebildet ist.

10. Wafermagazin gemäß einem der Ansprüche 7 bis 9, **dadurch gekennzeichnet, dass** jede untere und/oder obere Umlenkrolle um eine Drehachse (D) derart drehbar gelagert ist, dass das Führungsband unter einer Drehung einer unteren und/oder oberen Umlenkrolle entlang seiner Erstreckungsrichtung bewegbar ist.

11. Wafermagazin gemäß Anspruch 10, **dadurch gekennzeichnet, dass** die Drehachsen (D) der unteren und/oder oberen Umlenkrollen jeweils kugelgelagert ausgebildet sind.

12. Wafermagazin gemäß Anspruch 10 oder 11, **dadurch gekennzeichnet, dass** jede untere und/oder obere Umlenkrolle entlang ihrer Drehachse (D) betrachtet, gegenüber liegende Führungswangen (105) zur seitlichen Führung des Führungsbandes aufweist.

13. Wafermagazin gemäß einem der vorangehenden Ansprüche 7 bis 12, **dadurch gekennzeichnet, dass** jede untere und/oder obere Umlenkrolle als Zahnrad und das Führungsband zumindest abschnittsweise als ein mit zumindest einem Zahnrad zusammenwirkender Zahnriemen ausgebildet ist.

## Claims

1. Wafer magazine for semiconductor wafers or wafer-like objects, comprising
• a base body (1) resting on a base surface,
• a plurality of boundary structures (10) which are fixed to the base body (1) and run transversely to the base surface, and
• a base plate (2) which rests on the base body (1) between the boundary structures (10) and which can be moved along the boundary structures (10) along a traversing direction (V) which is oriented substantially perpendicularly to the base surface,
wherein a plurality of the boundary structures (10) each comprise an inner side (11) facing the base plate (2) and a respective guide device (100) with a guide means (101) extending at least on the inner side (11) of a boundary structure (10), wherein the guide means (101) are of flexible design transversely to the traversing direction (V) or cooperates with the base plate (2) in such a way that the movement of the base plate (2) along the traversing direction (V) brings about a movement of the guide means (101) which is oriented substantially along the traversing direction (V) and is of substantially the same speed,
**characterized in that**
the guide means (101) are arranged such that a wafer or wafer-like object to be disposed on the base plate (2) comes into mechanical contact with the plurality of the boundary structures (10) via the guide means (101), only.

2. Wafer magazine according to claim 1, **characterized in that** the guide means (101) are mechanically fixed to the base plate (2).

3. Wafer magazine according to claim 2, **characterized in that** the base plate (2) is so heavy that its weight force is greater than the sum of all motion-inhibiting forces acting on the base plate (2) when the base plate (2) moves along the traversing direction (V) via the guide means (101).

4. Wafer magazine according to one of claims 1 to 3, **characterized in that** each of the guide means is in the form of a guide belt arranged adjacent to the inside (11) of a boundary structure (10).

5. Wafer magazine according to claim 4, **characterized in that** each of the guide devices (100) comprises an upper positioning means (102) and a lower positioning means (103) for positioning the guide belt.

6. Wafer magazine according to claim 5, **characterized in that** each guide belt is positioned in a distance from the adjacent inside (11) of a boundary structure (10).

7. Wafer magazine according to claim 5 or 6, **characterized in that** each of the upper positioning means (102) is designed as an upper deflection roller for deflecting the guide belt by substantially 180°, the guide belt extending from the inside (11) of a boundary structure (10) to an outside (12) of the boundary structure (10) facing away from the base plate (2).

8. Wafer magazine according to claim 7, **characterized in that** each guide device (100) has a tensioning device (104) arranged between the upper deflection roller and the base body (1) and mechanically tensioning the guide belt along its extension direction.

9. Wafer magazine according to claim 8, **characterized in that** each one of the lower positioning means (103) is formed as a lower deflection roller (103) for deflecting the guide belt by substantially 180°, wherein the guide belt extends from the inside (11) of the boundary structure (10) to the outside (12) of the boundary structure (10) and is formed as a circumferential, one-piece strap.

10. Wafer magazine according to one of claims 7 to 9, **characterized in that** each lower and/or the upper deflection roller is rotatably mounted about an axis of rotation (D) in such a way that the guide belt can be moved along its extension direction when the lower and/or the upper deflection roller is rotated.

11. Wafer magazine according to claim 10, **characterized in that** the axis of rotation of the lower and/or the upper deflection rollers each are formed ball bearing mounted.

12. Wafer magazine according to claim 10 or 11, **characterized in that** each of the lower and/or the upper deflection roller, viewed along its axis of rotation (D), has opposite guide cheeks (105) for lateral guidance of the guide belt.

13. Wafer magazine according to one of the preceding claims 7 to 12, **characterized in that** each of the lower and/or the upper deflection roller is designed as a gear wheel and the guide belt is designed at least in sections as a toothed belt cooperating with at least one gear wheel.

## Revendications

1. Magasin de plaquettes pour des plaquettes de semiconducteurs ou des objets similaires, avec
• un corps de base (1), qui repose sur une face de base,
• une multiplicité de structures de limitation (10), qui sont fixées au corps de base (1) et qui s'étendent transversalement à la face de base, et
• une plaque de base (2) reposant sur le corps de base (1) entre les structures de limitation (10), qui peut être déplacée le long des structures de limitation (10) selon une direction de déplacement (V) orientée essentiellement perpendiculairement à la face de base,
dans lequel plusieurs des structures de limitation (10) comprennent respectivement un côté intérieur (11) tourné vers la plaque de base (2) et respectivement un dispositif de guidage (100) avec un moyen de guidage (101) s'étendant au moins sur le côté intérieur (11) d'une structure de limitation (10), et dans lequel les moyens de guidage (101) sont flexibles transversalement à la direction de déplacement (V) ou coopèrent avec la plaque de base (2), de telle manière que le mouvement de la plaque de base (2) selon la direction de déplacement (V) provoque un mouvement des moyens de guidage (101) orienté essentiellement selon la direction de déplacement (V) et essentiellement aussi rapide,
**caractérisé en ce que** les moyens de guidage (101) sont disposés de telle manière qu'une plaquette ou un objet similaire à disposer sur la plaque de base (2) ne vienne en contact mécanique avec lesdites plusieurs des structures de limitation (10) que par les moyens de guidage (101).

2. Magasin de plaquettes selon la revendication 1, **caractérisé en ce que** les moyens de guidage (101) sont fixés mécaniquement à la plaque de base (2).

3. Magasin de plaquettes selon la revendication 2, **caractérisé en ce que** la plaque de base (2) est tellement lourde, que son poids est supérieur à la somme de toutes les forces s'opposant au mouvement qui agissent sur la plaque de base (2) par l'intermédiaire des moyens de guidage (101) lors d'un mouvement de la plaque de base (2) selon la direction de déplacement (V).

4. Magasin de plaquettes selon l'une quelconque des revendications 1 à 3, **caractérisé en ce que** les moyens de guidage (101) sont réalisés respectivement sous la forme d'une bande de guidage disposée à proximité du côté intérieur (11) d'une structure de limitation (10).

5. Magasin de plaquettes selon la revendication 4, **caractérisé en ce que** les dispositifs de guidage (100) présentent respectivement un moyen de positionnement supérieur (102) et un moyen de positionnement inférieur (103) pour le positionnement de la bande de guidage.

6. Magasin de plaquettes selon la revendication 5, **caractérisé en ce que** chaque bande de guidage est espacée du côté intérieur voisin d'une structure de limitation (10).

7. Magasin de plaquettes selon la revendication 5 ou 6, **caractérisé en ce que** chaque moyen de positionnement supérieur (102) est formé par un rouleau de renvoi pour dévier une bande de guidage essentiellement de 180°, dans lequel la bande de guidage s'étend depuis le côté intérieur (11) d'une structure de limitation (10) jusqu'à un côté extérieur (12) de la structure de limitation (10) détourné de la plaque de base (2).

8. Magasin de plaquettes selon la revendication 7, **caractérisé en ce que** chaque dispositif de guidage (100) présente un dispositif de serrage (104) disposé entre le rouleau de renvoi supérieur et le corps de base (1), qui précontraint mécaniquement la bande de guidage selon sa direction d'extension.

9. Magasin de plaquettes selon la revendication 7, **caractérisé en ce que** chaque moyen de positionnement inférieur (103) est formé par un rouleau de renvoi pour dévier la bande de guidage essentiellement de 180°, dans lequel la bande de guidage s'étend depuis le côté intérieur (11) de la structure de limitation (10) jusqu'au côté extérieur (12) de la structure de limitation (10) et est formée par une courroie rotative en une seule pièce.

10. Magasin de plaquettes selon l'une quelconque des revendications 7 à 9, **caractérisé en ce que** chaque rouleau de renvoi inférieur et/ou supérieur est monté de façon rotative autour d'un axe de rotation (D), de telle manière que la bande de guidage puisse être mise en mouvement selon sa direction d'extension par une rotation d'un rouleau de renvoi inférieur et/ou supérieur.

11. Magasin de plaquettes selon la revendication 10, **caractérisé en ce que** les axes de rotation (D) des rouleaux de renvoi inférieurs et/ou supérieurs sont chacun montés sur des roulements à billes.

12. Magasin de plaquettes selon la revendication 10 ou 11, **caractérisé en ce que** chaque rouleau de renvoi inférieur et/ou supérieur, considéré le long de son axe de rotation (D), présente des joues de guidage opposées l'une à l'autre (105) pour le guidage latéral de la bande de guidage.

13. Magasin de plaquettes selon l'une quelconque des revendications précédentes 7 à 12, **caractérisé en ce que** chaque rouleau de renvoi inférieur et/ou supérieur est formé par une roue dentée et la bande de guidage est formée au moins localement par une courroie crantée coopérant avec au moins une roue dentée.
